# FASCICULE DE BREVET EUROPEEN

(11) **EP 1 439 574 B1**
(45) Date de publication et mention de la délivrance du brevet: **02.11.2005**
(21) Numéro de dépôt: 03300274.2
(22) Date de dépôt: 22.12.2003
(51) Int. Cl.: H01L 21/28, H01L 21/02, H01L 21/316, H01L 21/336

(54) **Procédé de formation d'une région localisée d'un matériau difficilement gravable**
Verfahren zur Formung eines lokalisierten Gebietes aus einem schwierig zu ätzenden Material
Process of forming a localised region of a material which is difficult to etch

(30) Priorité: 27.12.2002 FR 0216800
(43) Date de publication de la demande: 21.07.2004
(73) Titulaire: STMicroelectronics S.A., 92120 Montrouge (FR)
(72) Inventeur: Halimaoui, Aomar, 38660 La Terrasse (FR); Bensahel, Daniel, 38100 Grenoble (FR)
(74) Mandataire: de Beaumont, Michel

(56) Documents cités:
- EP-A- 1 089 344
- EP-A- 1 227 513
- EP-A- 1 246 254
- US-A- 6 074 919
- US-B1- 6 300 203

## Description

La présente invention concerne, de façon générale, la formation de circuits intégrés sur un substrat de silicium. Plus particulièrement, la présente invention concerne la formation de régions localisées d'un matériau difficilement gravable. Par difficilement gravable, on entend dans la présente description un manque de sélectivité de gravure par rapport aux matériaux utilisés dans la filière standard de formation de circuits sur silicium, ou le fait que les produits chimiques utilisables seraient polluants pour les autres éléments du circuit intégré.

De tels matériaux sont, par exemple, des matériaux à permittivité diélectrique élevée destinés à constituer l'isolant inter-électrode d'un élément capacitif ou un isolant de grille de transistor MOS. Par matériaux à permittivité diélectrique élevée, on désigne dans la présente description des isolants de permittivité diélectrique jusqu'à cent à mille fois supérieure à celle de l'oxyde de silicium (SiO₂). Parmi de tels isolants, on trouve les oxydes métalliques de type MO₂, MSiₓO_{y} ou MAlₓO_{y}, où x et y désignent des entiers et M un atome métallique choisi parmi le groupe comprenant l'hafnium, le zirconium, le lanthane et l'aluminium.

Plus particulièrement, la présente invention concerne la formation de tels éléments comportant un isolant de permittivité diélectrique élevée.

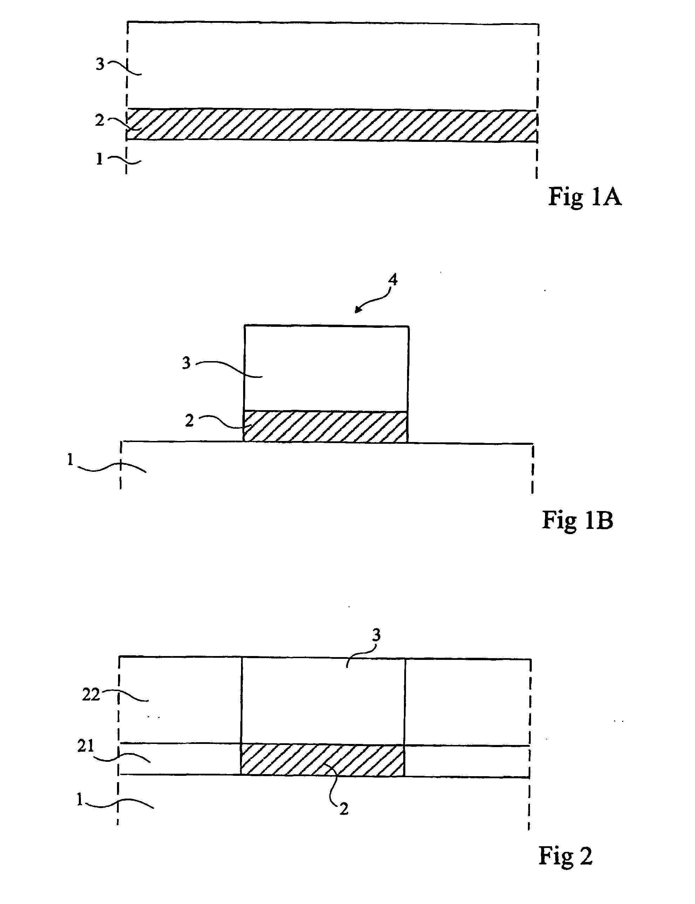

Les figures 1A et 1B illustrent, en vue en coupe schématique et partielle, des étapes successives de formation d'une grille isolée d'un transistor MOS selon un procédé connu.

Comme l'illustre la figure 1A, on dépose successivement sur un substrat semiconducteur 1, typiquement du silicium, une couche mince d'un isolant 2 puis une couche conductrice 3.

Ensuite, comme l'illustre la figure 1B, on définit une grille isolée 4 en gravant l'empilement de l'isolant 2 et de la couche conductrice 3. L'isolant 2 est typiquement un oxyde de silicium (SiO₂) résultant soit d'un dépôt chimique en phase vapeur (CVD), soit d'une oxydation thermique de la surface du substrat 1. La couche conductrice 3, destinée à constituer l'électrode de grille, est généralement du silicium polycristallin.

Dans les technologies modernes, les longueurs de grille sont de plus en plus réduites, et il faut réduire l'épaisseur de l'isolant 2. Toutefois, il n'est pas possible, pour des raisons physiques, de réduire l'épaisseur d'un isolant en deçà d'une certaine limite de l'ordre de 1,5 nm. Ceci limite la possibilité de réduction des dimensions de l'électrode de grille.

Pour permettre une réduction supplémentaire de dimensions, on a cherché à utiliser comme isolant 2 des matériaux isolants à permittivité diélectrique élevée. Toutefois, ces isolants sont difficilement gravables. Pour éviter toute gravure, on a pensé mettre en oeuvre un procédé de type damascène.

La figure 2 illustre, en vue en coupe partielle et schématique, une étape intermédiaire d'un procédé damascène. Un tel procédé consiste à répéter, pour chaque élément isolant 2 ou conducteur destiné à former la grille isolée, la succession d'étapes consistant à déposer une couche isolante, à l'ouvrir selon le contour de la grille, à déposer la couche du matériau isolant difficilement gravable, et à effectuer un aplanissement de la surface, généralement par polissage mécano-chimique (CMP). La structure ainsi obtenue est illustrée en figure 2, dans laquelle la référence 21 désigne un premier isolant, la référence 2 l'isolant de grille difficilement gravable, la référence 22 un deuxième isolant, et la référence 3 le conducteur de grille. Ensuite, pour retrouver la structure illustrée en figure 1B, on élimine sélectivement les isolants 21 et 22.

Ce procédé présente divers inconvénients. Notamment, on utilise comme couches intermédiaires 21, 22 des couches isolantes dont l'une au moins est habituellement de nitrure de silicium. Le nitrure de silicium impose sur le substrat 1 sous-jacent des contraintes mécaniques telles que sa structure cristallographique est déformée. Ceci affecte les performances non seulement de l'élément capacitif formé mais également des dispositifs voisins. En particulier, dans le cas de la formation d'un transistor, les profils de dopage du canal et des régions de source/drain ultérieurement formées sont affectés.

Des problèmes similaires sont rencontrés lors de l'intégration de tout élément capacitif comportant comme isolant inter-électrode un isolant de permittivité diélectrique élevée.

La présente invention vise à proposer un procédé de formation localisée d'un matériau isolant à permittivité diélectrique élevée.

La présente invention vise à proposer un tel procédé qui pallie les inconvénients des procédés connus.

La présente invention vise à proposer un tel procédé qui permet la formation d'une grille isolée d'un transistor MOS.

La présente invention vise également à proposer un tel procédé qui permet la formation d'un condensateur de type métal-isolant-métal (MIM).

Pour atteindre ces objets, la présente invention prévoit un procédé de formation, dans un circuit intégré, d'une région localisée d'un matériau difficilement gravable, comportant les étapes consistant à former une première couche d'oxyde de silicium d'épaisseur inférieure à 1 nm sur un substrat de silicium ; déposer, sur la première couche, une deuxième couche gravable sélectivement par rapport à la première couche ; former dans la deuxième couche une ouverture selon le motif de ladite région localisée ; faire croître sélectivement sur la deuxième couche, autour de l'ouverture, une couche de germanium, le matériau de la deuxième couche étant choisi pour permettre cette croissance sélective, d'où il résulte qu'il existe dans le germanium une ouverture conforme à la susdite ouverture ; déposer le matériau difficilement gravable de sorte qu'il ne se dépose pas sur le germanium ; déposer une couche conductrice de façon à remplir l'ouverture dans le germanium ; procéder à un aplanissement de façon à découvrir le germanium ; et éliminer le germanium et les première et deuxième couches.

Selon un mode de réalisation de la présente invention, le substrat est en silicium.

Selon un mode de réalisation de la présente invention, la deuxième couche est en silicium amorphe.

Selon un mode de réalisation de la présente invention, la deuxième couche a une épaisseur de 2 à 3 nm.

Selon un mode de réalisation de la présente invention, la première couche d'oxyde a une épaisseur de 0,5 à 0,7 nm.

Selon un mode de réalisation de la présente invention, le germanium est déposé à partir d'un mélange de germane et d'hydrogène à une température de 350 à 600°C.

Selon un mode de réalisation de la présente invention, le matériau difficilement gravable étant un isolant de permittivité diélectrique élevée choisi dans le groupe comprenant MO₂, MSiₓO_{y} ou MAlₓO_{y}, où x et y désignent des entiers, et M un atome métallique choisi parmi le groupe comprenant l'hafnium, le zirconium, le lanthane et l'aluminium.

Selon un mode de réalisation de la présente invention, le dépôt du matériau difficilement gravable est effectué par un procédé de dépôt chimique en phase vapeur par couche atomique (ALPCVD).

Selon un mode de réalisation de la présente invention, le dépôt du matériau difficilement gravable est précédé d'une élimination de la partie découverte de la première couche d'oxyde au fond de l'ouverture et d'un traitement propre à privilégier la croissance du matériau difficilement gravable sur le substrat plutôt que sur le germanium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B illustrent, en vue en coupe schématique et partielle, des étapes d'un procédé connu de formation d'une grille isolée d'un transistor MOS ;
la figure 2 illustre, en vue en coupe schématique et partielle, l'état d'une grille isolée d'un transistor MOS à une étape intermédiaire de sa formation selon un autre procédé connu ; et
les figures 3A à 3G illustrent, en vue en coupe schématique et partielle, des étapes successives d'un procédé de formation d'une grille isolée selon un mode de réalisation de la présente invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

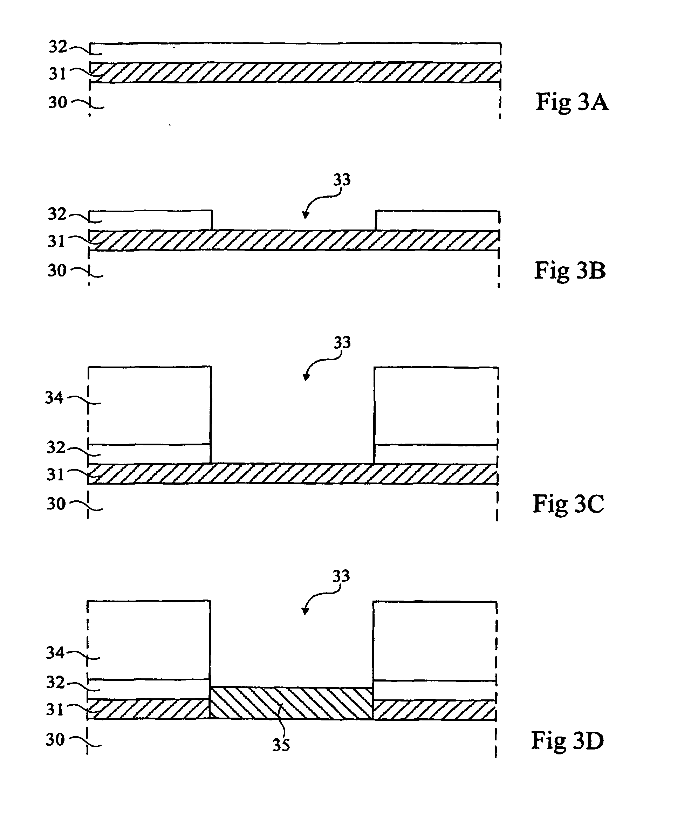

Les figures 3A à 3G illustrent, en vue en coupe schématique et partielle, des étapes successives d'un procédé de formation d'une grille isolée d'un transistor MOS selon un mode de réalisation de la présente invention.

Comme l'illustre la figure 3A, le procédé selon l'invention commence par la formation, sur un substrat semiconducteur monocristallin 30, d'une couche mince 31. La couche 31 est gravable sélectivement par rapport au substrat sous-jacent 30. Des éléments supplémentaires de sélection de la nature et de l'épaisseur de la couche 31 seront détaillés dans la suite.

Par exemple, en supposant que le substrat 30 est en silicium, la couche 31 est de préférence, une couche d'oxyde de silicium formée, par oxydation thermique ou par dépôt CVD, sur une épaisseur correspondant à quelques couches atomiques, comprise entre 0,5 et 0,7 nm.

On dépose ensuite une couche 32 d'un matériau gravable sélectivement par rapport à la couche 31. D'autres critères de choix de la nature et de l'épaisseur de la couche 32 seront exposés ci-après. La couche 32 est par exemple, une couche de silicium amorphe, déposée à basse température, d'une épaisseur comprise entre 2 et 3 nm.

Comme l'illustre la figure 3B, on forme dans la couche de silicium 32 une ouverture 33. L'ouverture 33 présente, en vue de dessus (non représentée) le contour que l'on souhaite conférer à une grille isolée d'un transistor MOS et à une prise de contact d'une telle électrode.

Comme l'illustre la figure 3C, on provoque aux étapes suivantes un dépôt sélectif d'une couche 34 sur la seule couche 32 autour de l'ouverture 33. L'ouverture 33 se trouve donc approfondie de l'épaisseur de la couche 34. L'épaisseur de la couche 34 est égale à l'épaisseur que l'on souhaite conférer à la grille isolée, par exemple, de l'ordre de 100 à 200 nm.

La couche 34 est en un matériau susceptible d'être déposé sélectivement sur la couche 32 sans être déposé sur le matériau constituant la couche 31 présent au fond de l'ouverture 33. La couche 34 est, par exemple, du germanium monocristallin ou polycristallin.

En effet, selon la présente invention, il est possible de faire croître du germanium à la surface d'un matériau tel que le silicium à partir d'un mélange de 1 à 20% de germane dans de l'hydrogène à des températures relativement basses, comprises entre 350 et 650°C. La croissance se fait alors sélectivement, aucun dépôt ne se produit sur les surfaces revêtues de la couche d'oxyde 31. De plus, cette croissance est sensiblement verticale. A titre d'exemple, on obtient un dépôt de germanium à une vitesse de croissance de 2 nm/heure en prenant un débit de GeH₄ (à 10% dans H₂) de 500 cm³/mn, un débit d'hydrogène de 20 P/mn et une température de 450°C.

Ensuite on dépose dans l'ouverture 33 un isolant à permittivité diélectrique élevée 35, comme l'illustre la figure 3D, sélectivement seulement au fond de l'ouverture 33. Cette étape importante de la présente invention sera détaillée ci-après.

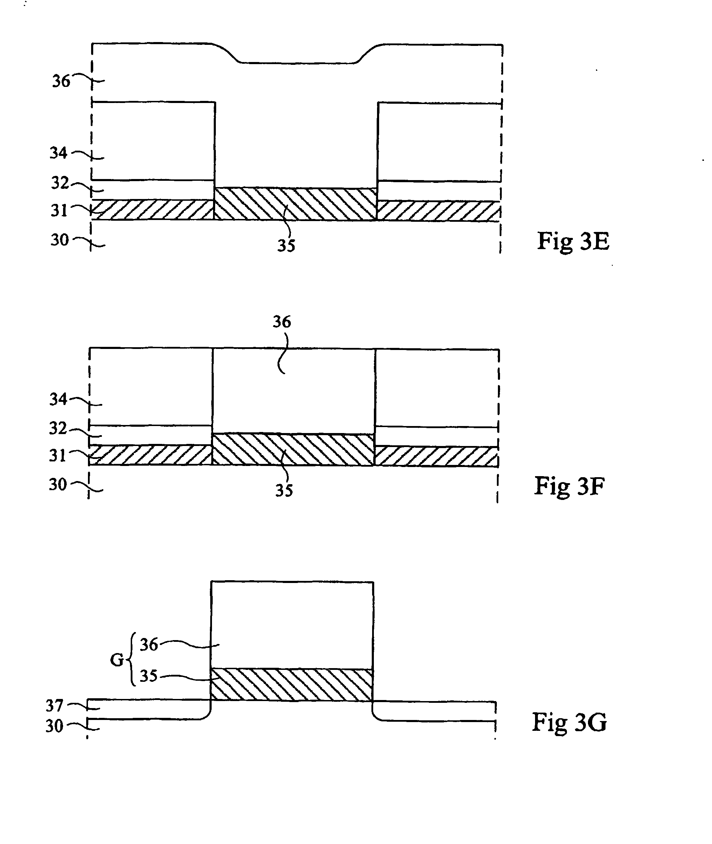

Le procédé se poursuit, comme l'illustre la figure 3E, par le dépôt sur l'ensemble de la structure d'au moins une couche conductrice 36, par exemple du silicium polycristallin, de façon à remplir complètement l'ouverture 33.

Comme l'illustre la figure 3F, on procède à un aplanissement, par exemple par un polissage mécano-chimique (CMP), de façon à éliminer la couche conductrice 36 de la surface supérieure de la couche de germanium 34. Ensuite, la couche de germanium 34, la couche de silicium 32 et la couche d'oxyde de silicium 31 sont successivement éliminées par des gravures sélectives.

On a ainsi obtenu, comme l'illustre la figure 3G, une grille G constituée d'une électrode de grille 36 isolée du substrat 30 sous-jacent par un isolant 35 de permittivité diélectrique élevée.

Le procédé de formation d'un transistor MOS se poursuit ensuite, par exemple, par la formation de régions de drain/source faiblement dopées (LDD) 37, d'espaceurs, de régions de drain et de source et de contacts (non représentés).

Le procédé selon l'invention permet avantageusement d'éliminer l'étape classique critique de gravure de l'isolant de grille. Il est donc possible d'utiliser des isolants à permittivité diélectrique élevée.

Un autre avantage du procédé selon la présente invention réside en ce que, compte tenu de la valeur élevée de sa permittivité diélectrique, le contrôle de l'épaisseur de l'isolant inter-électrode est moins critique.

Un autre avantage du procédé selon la présente invention est de permettre le recours à un procédé comportant une unique étape d'alignement d'un masque. En effet, le seul masque de définition de l'ouverture 33 permet de définir la grille. Ensuite, la formation de la grille s'effectue de façon auto-alignée.

Un autre avantage de la présente invention est d'obtenir ces résultats avec des contraintes mécaniques sur le substrat sous-jacent très limitées. En effet, les contraintes imposées par un matériau tel que le germanium sont bien moindres que celles exercées par un matériau tel que le nitrure de silicium.

En outre, le germanium présente l'avantage de pouvoir être éliminé dans des conditions très sélectives et peu agressives, même sur une épaisseur de quelques centaines de nanomètres.

On a décrit en relation avec la figure 3D un mode de réalisation selon lequel le dépôt de l'isolant à permittivité diélectrique élevée 35 est effectué sélectivement seulement au fond de l'ouverture 33 et non pas sur la couche périphérique 34. Un tel dépôt sélectif est possible, selon l'invention, en mettant en oeuvre un procédé de dépôt chimique en phase vapeur par couche atomique (ALCVD ou Atomic Layer Chemical Vapor Deposition) sur une surface de silicium ayant subi une préparation spécifique. Une telle préparation a pour objet de former une surface comportant de nombreux sites de nucléation. Elle peut consister en un nettoyage de la surface de silicium propre à laisser en place des terminaisons spécifiques telles que des terminaisons OH, en un dopage de très faible concentration et à faible énergie de dopants sélectionnés, ou encore en la formation d'une couche sacrificielle d'initiation.

Ainsi, dans le cas de la croissance d'une couche d'oxyde de zirconium ou d'oxyde d'hafnium, on a montré que la sélectivité de croissance sera obtenue par des sites de nucléation de type terminaison hydroxyde OH. De tels sites sont, par exemple, présents en très grand nombre à la surface d'un oxyde de silicium alors qu'ils sont presque inexistants à la surface du silicium.

En l'absence de préparation préalable, les sites de nucléation se forment pendant le dépôt de l'isolant à permittivité élevée. Dans l'exemple considéré des oxydes de zirconium ou d'hafnium, ceux-ci doivent commencer par réagir avec le substrat de silicium pour l'oxyder afin d'amorcer leur croissance.

Des expériences des inventeurs ont montré que la sélectivité de dépôt entre une surface de silicium préparée et une surface de germanium est extrêmement élevée. En outre, la plupart des préparations permettant de provoquer une croissance d'une couche d'un isolant à permittivité élevée sur une surface de silicium sont sans effet sur une surface de germanium.

Ainsi, la présence, au fond de l'ouverture 33 (figure 2C), de la couche très mince d'oxyde de silicium 31 du mode de réalisation décrit en relation avec la figure 3 permet d'obtenir la sélectivité recherchée.

L'homme de l'art saura adapter la préparation de la surface du substrat 30 au fond de l'ouverture 33 à l'isolant à permittivité élevée déposé. Par exemple, la nature de la couche 31 peut être modifiée. Selon d'autres modes de réalisation, après la croissance sélective de la couche 34 autour de l'ouverture 33, on élimine la couche 31 et on met en oeuvre une préparation spécifique à l'isolant 35 ultérieurement déposé. La préparation peut également consister dans le dépôt, sur le substrat 30, d'une couche d'initiation spécifique au début du procédé, avant le dépôt (figure 1A) de la couche 31.

Bien entendu, la présente invention est susceptible de diverses variantes et modifications qui apparaîtront à l'homme de l'art. En particulier, on a décrit l'invention dans le cadre de la formation localisée d'une région isolante destinée à constituer l'isolant inter-électrode d'un élément capacitif. Toutefois, l'homme de l'art saura adapter le procédé selon l'invention à la formation d'une région localisée d'un matériau isolant ou conducteur difficilement gravable dans une filière donnée.

De plus, la présente invention a été décrite dans le cas de la formation de grilles isolées de transistor MOS et de condensateurs de type MIM. L'homme de l'art comprendra que la présente invention s'applique à la formation de tout type d'éléments capacitifs dont le diélectrique inter-électrode est un diélectrique à forte permittivité, tels que des doubles grilles isolées de transistors, des condensateurs réalisés directement sur un substrat semiconducteur ou dans des niveaux intermédiaires d'un circuit intégré ou des condensateurs de type métal-isolant-métal (MIM) formés dans des niveaux de métallisation. Le cas échéant, une première électrode conductrice remplace le substrat de silicium de la description précédente et une deuxième électrode remplace l'électrode de grille de la description précédente.

En outre, par substrat on a désigné dans la présente description autant une tranche de silicium uniformément dopée que des zones épitaxiées et/ou spécifiquement dopées par implantation/diffusion formées sur ou dans un substrat massif.

## Revendications

1. Procédé de formation, dans un circuit intégré, d'une région localisée d'un matériau difficilement gravable (35), **caractérisé en ce qu'**il comporte les étapes suivantes :
former une première couche (31) d'oxyde de silicium d'épaisseur inférieure à 1 nm sur un substrat (30) ;
déposer, sur la première couche, une deuxième couche (32) gravable sélectivement par rapport à la première couche ;
former dans la deuxième couche une ouverture (33) selon le motif de ladite région localisée ;
faire croître sélectivement sur la deuxième couche, autour de l'ouverture, une couche de germanium (34), le matériau de la deuxième couche étant choisi pour permettre cette croissance sélective, d'où il résulte qu'il existe dans le germanium une ouverture conforme à la susdite ouverture ;
déposer le matériau difficilement gravable (35) de sorte qu'il ne se dépose pas sur le germanium ;
déposer une couche conductrice (36) de façon à remplir l'ouverture dans le germanium ;
procéder à un aplanissement de façon à découvrir le germanium ; et
éliminer le germanium et les première et deuxième couches.

2. Procédé selon la revendication 1, dans lequel le substrat (30) est en silicium.

3. Procédé selon la revendication 1, dans lequel la deuxième couche (32) est en silicium amorphe.

4. Procédé selon la revendication 1, dans lequel la deuxième couche (32) a une épaisseur de 2 à 3 nm.

5. Procédé selon la revendication 1, dans lequel la première couche d'oxyde (31) a une épaisseur de 0,5 à 0,7 nm.

6. Procédé selon la revendication 1, dans lequel le germanium (34) est déposé à partir d'un mélange de germane et d'hydrogène à une température de 350 à 650°C.

7. Procédé selon la revendication 1, dans lequel le matériau difficilement gravable est un isolant de permittivité diélectrique élevée (35) choisi dans le groupe comprenant MO₂, MSiₓO_{y} ou MAlₓO_{y}, où x et y désignent des entiers et M un atome métallique choisi parmi le groupe comprenant l'hafnium, le zirconium, le lanthane et l'aluminium.

8. Procédé selon la revendication 1, dans lequel le dépôt du matériau difficilement gravable (35) est effectué par un procédé de dépôt chimique en phase vapeur par couche atomique (ALPCVD).

9. Procédé selon la revendication 1, dans lequel le dépôt du matériau difficilement gravable (35) est précédé d'une élimination de la partie découverte de la première couche d'oxyde (31) au fond de l'ouverture (33) et d'un traitement propre à privilégier la croissance du matériau difficilement gravable (35) sur le substrat (30) plutôt que sur le germanium (34).

## Claims

1. A method for forming, in an integrated circuit, a localized region of a material difficult to etch (35), **characterized in that** it comprises the steps of:
forming a first silicon oxide layer (31) having a thickness smaller than 1 nm on a silicon substrate (30);
depositing, on the first layer, a second layer (32) selectively etchable with respect to the first layer;
forming in the second layer an opening (33) according to the pattern of said localized region;
selectively growing on the second layer, around the opening, a germanium layer (34), the material of the second layer being chosen to enable this selective growth, whereby there exists in the germanium an opening conformable with the above opening;
depositing the material difficult to etch (35) so that it does not deposit on the germanium;
depositing a conductive layer (36) to fill the opening in the germanium;
performing a leveling to expose the germanium; and
removing the germanium and the first and second layers.

2. The method of claim 1, wherein the substrate (30) is made of silicon.

3. The method of claim 1, wherein the second layer (32) is made of amorphous silicon.

4. The method of claim 1, wherein the second layer (32) has a thickness from 2 to 3 nm.

5. The method of claim 1, wherein the first oxide layer (31) has a thickness of from 0.5 to 0.7 nm.

6. The method of claim 1, wherein the germanium (34) is deposited from a germane and hydrogen mixture at a temperature from 350 to 650°C.

7. The method of claim 1, wherein the material difficult to etch is an insulator with a high dielectric permittivity (35) selected from the group comprising MO₂, MSiₓO_{y}, or MAlₓO_{y}, where x and y designate integers, and M a metal atom selected from the group comprising hafnium, zirconium, lanthanum, and aluminum.

8. The method of claim 1, wherein the deposition of the material difficult to etch (35) is performed by an atomic layer chemical vapor deposition method (ALPCVD).

9. The method of claim 1, wherein the deposition of the material difficult to etch (35) is preceded with a removal of the exposed portion of the first oxide layer (31) at the bottom of the opening (33) and with a processing capable of privileging the growth of the material difficult to etch (35) on the substrate (30) rather than on the germanium (34).

## Patentansprüche

1. Ein Verfahren zum Ausbilden in einer integrierten Schaltung eines lokalisierten Bereichs aus einem schwierig zu ätzenden Material (35), **dadurch gekennzeichnet, dass** das Verfahren die folgenden Schritte aufweist: Ausbilden einer ersten Siliziumoxidschicht (31) mit einer Dicke, die kleiner als 1 nm ist, auf einem Siliziumsubstrat (30);
Abscheiden auf der ersten Schicht einer zweiten Schicht (32), die selektiv bezüglich der ersten Schicht ätzbar ist;
Ausbilden in der zweiten Schicht einer Öffnung (33) gemäß dem Muster des lokalisierten Bereichs;
selektives Aufwachsen auf der zweiten Schicht um die Öffnung herum einer Germaniumschicht (34), wobei das Material der zweiten Schicht so ausgewählt ist, dass sie dieses selektive Wachstum ermöglicht, wodurch in dem Germanium eine Öffnung besteht, die mit der obigen Öffnung konform ist;
Abscheiden des schwierig zu ätzenden Materials (35), derart dass es sich nicht auf dem Germanium abscheidet;
Abscheiden einer leitenden Schicht (36) zum Füllen der Öffnung in dem Germanium;
Durchfuhren einer Einebnung bzw. Planarisierungzum Freilegen des Germaniums; und
Entfernen des Germaniums und der ersten und zweiten Schichten

2. Verfahren nach Anspruch 1, wobei das Substrat (30) aus Silizium hergestellt ist.

3. Verfahren nach Anspruch 1, wobei die zweite Schicht (32) aus amorphem Silizium besteht.

4. Verfahren nach Anspruch 1, wobei die zweite Schicht (32) eine Dicke von 2 bis 3 nm besitzt

5. Verfahren nach Anspruch 1, wobei die erste Oxidschicht (31) eine Dicke von 0,5 bis 0,7 nm besitzt.

6. Verfahren nach Anspruch 1, wobei das Germanium (34) aus einer German- und Wasserstoffmischung bei einer Temperatur von 350 bis 650°C abgeschieden wird.

7. Verfahren nach Anspruch 1, wobei das schwierig zu ätzende Material ein Isoliermaterial mit einer hohen dielektrischen Permitivität (35) ist, das aus der Gruppe bestehend aus MO₂, MSiₓO_{y} oder MAlₓO_{y} ausgewählt ist, wobei x und y ganze Zahlen designieren und M ein Metallatom ist, ausgewählt aus der Gruppe bestehend aus Hafnium, Zirkonium, Lanthan und Aluminium.

8. Verfahren nach Anspruch 1, wobei die Abscheidung des schwierig zu ätzenden Materials (35) durch ein atomschichtchemisches Dampfabscheidungsverfahren (ALPCVD = atomic layer chemical vapor deposition method) durchgeführt wird.

9. Verfahren nach Anspruch 1, wobei der Abscheidung des schwierig zu ätzenden Materials (35) eine Entfernung des freiliegenden Teils der ersten Oxidschicht (31) am Boden der Öffnung (33) vorgestellt ist, und zwar mit einem Prozess, der in der Lage ist, das Wachstum des schwierig zu ätzenden Materials (35) auf dem Substrat (30) statt auf dem Germanium (34) zu bevorzugen.
